# DEMANDE DE BREVET EUROPEEN

(11) **EP 0 736 971 A1**
(43) Date de publication de la demande: **09.10.1996**
(21) Numéro de dépôt: 96200857.9
(22) Date de dépôt: 28.03.1996
(51) Int. Cl.: H03H 7/07

(54) **Circuit réjecteur à fréquence de réjection réglable**

(30) Priorité: 05.04.1995 FR 9504040
(71) Demandeur: PHILIPS ELECTRONIQUE GRAND PUBLIC, 92150 Suresnes (FR); Philips Electronics N.V., 5621 BA Eindhoven (NL)
(72) Inventeur: Dutilleul, Frédéric, 75008 Paris (FR)
(74) Mandataire: Caron, Jean

(57) **Abrégé**

Dans un circuit trappe de type T ponté, ayant un circuit RC delta (RR, C1, C2) et un circuit de type bouchon inductance-capacité en shunt (L, Cp), la capacité Cp est constituée au moyen de diodes à capacité variable (D1, D2), reliées par une résistance (8) à une tension de commande (Vtone), la résistance (RR) du T ponté est constituée à partir d'une diode PIN, dont le courant est commandé par la même tension de commande (Vtone) via une résistance (9).

Applications : télévision

## Description

La présente invention concerne un circuit réjecteur comportant une borne d'entrée, une borne de sortie et un noeud intermédiaire, muni d'une résistance variable entre la borne d'entrée et la borne de sortie, d'une première capacité entre la borne d'entrée et le noeud intermédiaire, d'une seconde capacité entre le noeud intermédiaire et la borne de sortie, et d'un ensemble constitué d'une inductance en parallèle avec une capacité dite capacité parallèle, ensemble connecté entre le noeud intermédiaire et une source de tension fixe.

Un tel circuit réjecteur est utilisé en télévision, entre autres dans un réseau de distribution par câble, notamment dans une tête de réseau, pour rejeter la fréquence d'oscillateur local lorsqu'on transpose la fréquence d'un signal vers une autre fréquence, comprise dans la bande UHF.

Par conséquent, la présente invention concerne également une tête de réseau d'une installation de distribution par câble.

Un tel circuit réjecteur est connu de l'art antérieur mentionné dans le document EP-A-0 203 343, qui enseigne que la capacité dite parallèle doit être extrêmement petite quand on désire des caractéristiques de réjection très pointues, et la résistance très grande, ce dont découlent des pertes d'insertion importantes. Il est préconisé de réaliser l'accord en fréquence en rendant l'inductance variable, et d'optimiser la valeur de l'atténuation au moyen de la résistance.

Un objet de l'invention est d'obtenir un circuit réjecteur ayant des pertes d'insertion faibles et des caractéristiques de réjection pointues, et dont de surcroît la fréquence de réjection soit réglable dans une gamme de fréquences en conservant ses performances dans l'ensemble de cette gamme.

Cet objet est atteint du fait que la capacité parallèle est variable et est constituée à partir d'au moins une diode à capacité variable, et que la résistance est constituée à partir d'un élément à résistance dynamique commandée.

L'invention est donc basée sur l'idée d'apporter un déphasage en utilisant dans l'ensemble parallèle une capacité dont la valeur ne soit pas négligeable, et de baser la sélection de la fréquence d'accord sur cette capacité, tout en faisant varier en correspondance la valeur de cette capacité et la valeur de la résistance.

Dans un mode de réalisation particulier, la capacité parallèle est constituée au moyen de deux diodes à capacité variable montées en série avec leurs sens de conduction opposés, dont le point commun est relié par une résistance ou par une inductance à une source de tension de commande.

Dans un autre mode de réalisation particulier, la résistance dynamique de l'élément à résistance dynamique commandée étant commandée par le courant continu qui le traverse, une extrémité de l'élément à résistance dynamique commandée est reliée par une résistance ou par une inductance à une source de tension de commande, et son autre extrémité est reliée par une résistance ou par une inductance à une source de tension fixe.

Avantageusement, la source de tension de commande à laquelle est relié le point commun des deux diodes à capacité variable est la même que celle à laquelle est relié l'élément à résistance dynamique commandée.

Ainsi le réglage de la capacité et de la résistance est à la fois simple et efficace.

Une tête de réseau d'une installation de distribution par câble comporte avantageusement un circuit réjecteur selon l'invention.

Ces aspects de l'invention ainsi que d'autres aspects plus détaillés apparaîtront plus clairement grâce à la description suivante d'un mode de réalisation constituant un exemple non limitatif.

La figure 1 représente schématiquement un circuit réjecteur de base.

La figure 2 représente un mode de réalisation complet d'un circuit réjecteur selon l'invention.

Le circuit réjecteur décrit ci-après est destiné à fournir une réjection pour une fréquence qui peut être ajustée entre environ 500 MHz et 800 MHz. Il est utilisé dans un ensemble de réception satellite avec distribution par câble, ensemble dans lequel un signal reçu d'un satellite en modulation de fréquence est remodulé en modulation d'amplitude, à fréquence relativement basse (par exemple 38,9 MHz), puis transposé dans la gamme UHF de 470-862 MHz : le circuit réjecteur sert alors à éliminer les résidus de l'oscillateur local, qui est susceptible d'être ajusté à une fréquence quelconque de la gamme UHF. Il est clair que l'invention pourrait aussi s'appliquer à d'autres fréquences, en changeant des valeurs numériques et des types de constituants.

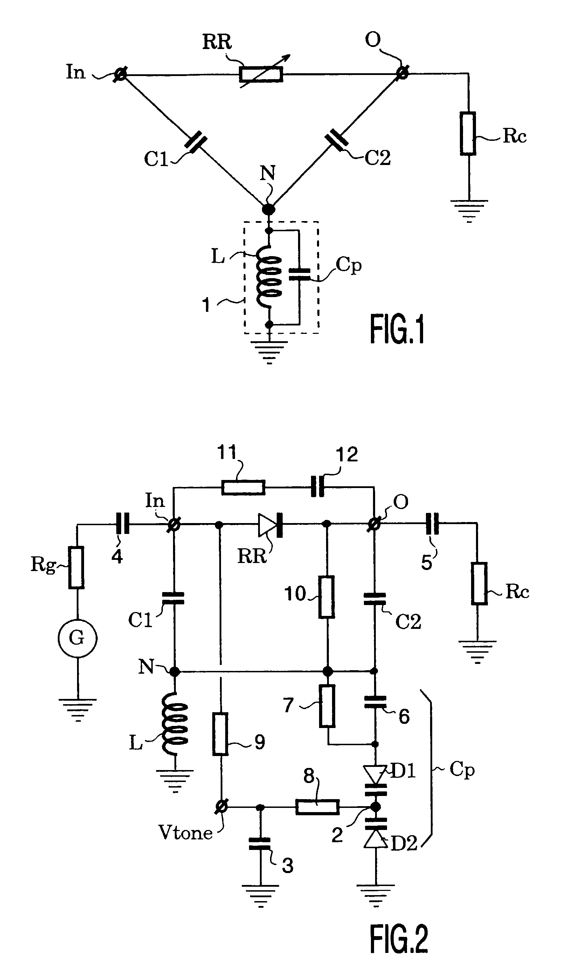

Le circuit de la figure 1 comporte une borne d'entrée In, une borne de sortie O et un noeud intermédiaire N. Il est muni d'une résistance variable RR entre la borne d'entrée In et la borne de sortie O, d'une première capacité C1 entre la borne d'entrée et le noeud intermédiaire, d'une seconde capacité C2 entre le noeud intermédiaire et la borne de sortie, et d'un ensemble 1 constitué d'une inductance L en parallèle avec une capacité Cp dite capacité parallèle, ensemble connecté entre le noeud intermédiaire N et une source de tension fixe, ici la masse. Une résistance de charge Rc, habituellement de 75 ohms, est connectée à la borne de sortie O.

Le principe de base mis en oeuvre dans ce schéma est le suivant :
- la branche RR - Rc fournit sur O un signal en phase avec celui à l'entrée In,
- à la fréquence de réjection, le réseau C1-L-Cp déphase d'un peu plus de 90°, le réseau C2-Rc déphase d'un peu moins de 90°, et l'ensemble C1-L-C2-Rc fournit sur O un signal déphasé de 180°, c'est-à-dire en opposition de phase avec celui fourni par RR - Rc,
- si le rapport RR / Rc est bien choisi, les deux signaux en opposition sont égaux en valeur absolue et s'annulent.

Le même raisonnement pourrait être fait en l'absence de Cp, mais la variation de phase autour du point de réjection est plus rapide en présence de Cp et l'impédance de l'ensemble 1 est plus élevée que celle de L seule, donc la réjection est plus pointue, et des valeurs de résistance faibles peuvent convenir pour RR. Les pertes d'insertion sont faibles.

La capacité parallèle Cp est réglable ainsi que la résistance dynamique de la résistance RR. Il est remarquable que l'on puisse ajuster la fréquence dans une gamme d'au moins 40%, tout en maintenant les performances, en agissant seulement sur RR et Cp.

Le circuit de la figure 2 comporte, comme celui de la figure 1, la borne d'entrée In, la borne de sortie O et le noeud intermédiaire N, la résistance variable RR, la capacité C1, la capacité C2, l'ensemble constitué de l'inductance L en parallèle avec la capacité Cp, et la résistance de charge Rc. Un générateur de tension d'entrée G de résistance interne Rg est connecté à l'entrée In. Une capacité 4 d'isolement galvanique est insérée dans le signal d'entrée amené à la borne d'entrée In. Une capacité 5 d'isolement galvanique est insérée dans le signal de sortie prélevé sur la borne de sortie O.

La capacité Cp est constituée par deux diodes à capacité variable dites "varicap", D1 et D2, montées en série avec leurs sens de conduction opposés, le tout en série avec une capacité fixe 6. Le point commun 2 des diodes varicap est relié par une résistance 8 à une borne de tension de commande Vtone. Cette résistance de 33 kΩ pourrait être remplacée par une inductance, toutefois plus coûteuse. Une seule diode pourrait être utilisée, mais cela pourrait compliquer légèrement le circuit de polarisation de cette diode. Une capacité de découplage 3 de 1 nF est connectée entre le borne Vtone et la masse.

La capacité 6 permet de modifier la forme de la fonction de variation de la capacité Cp avec la tension de commande. Pour maintenir une liaison galvanique, nécessaire pour la polarisation de la diode D1, une résistance 7 est disposée en parallèle sur la capacité 6.

La résistance variable RR est constituée par une diode dite PIN, qui a la propriété de présenter une résistance dynamique variable lorsqu'on fait varier le courant continu qui la traverse. Un courant est produit dans cette diode par une résistance 9 connectée entre Vtone et la borne In, courant qui se referme vers la masse via une autre résistance 10 disposée en parallèle sur C2, et via l'inductance L. En variante, la borne O peut aussi être reliée directement, c'est-à-dire sans la capacité 5, à la résistance de charge Rc de 75 Ω, auquel cas le courant se referme par Rc ; alors la valeur de la résistance 9 doit être ajustée en conséquence ; la capacité 4 pourrait aussi être supprimée à condition de tenir compte de la tension continue de sortie et de la résistance de sortie du générateur G.

Pour modifier la forme de la fonction de variation de la résistance variable RR avec la tension de commande, un ensemble formé d'une résistance 11 en série avec une capacité d'isolement 12 est placé en parallèle sur la résistance variable RR.

Pour constituer la résistance variable RR, on pourrait aussi utiliser un transistor MOS monté en résistance variable ; ceci entraînerait des changements importants, mais toutefois à la portée de l'homme du métier, dans la conception de la polarisation de commande de la valeur de la résistance RR.

Dans un mode de réalisation ayant donné de bons résultats, le modèle BB134 de la société Philips Composants est utilisé pour chacune des diodes D1 et D2, et le modèle HSMP-3800 de la société Hewlett Packard est utilisé pour la diode PIN ; les résistances 7 et 8 valent 33 kΩ chacune ; les capacités C1 et C2 valent 0,68 pF chacune ; l'inductance est faite d'un tour et demi de fil sur un mandrin de diamètre 3 mm ; la résistance 11 vaut 240 Ω et les capacités 3, 4, 5 et 12 valent 1 nF chacune ; la capacité 6 vaut 8,2 pF ; les résistances 9 et 10 valent 4,7 kΩ chacune.

## Revendications

1. Circuit réjecteur comportant une borne d'entrée, une borne de sortie et un noeud intermédiaire, muni d'une résistance variable entre la borne d'entrée et la borne de sortie, d'une première capacité entre la borne d'entrée et le noeud intermédiaire, d'une seconde capacité entre le noeud intermédiaire et la borne de sortie, et d'un ensemble constitué d'une inductance en parallèle avec une capacité, dite capacité parallèle, ensemble connecté entre le noeud intermédiaire et une source de tension fixe, caractérisé en ce que la capacité parallèle est variable et constituée à partir d'au moins une diode à capacité variable, et en ce que la résistance est constituée à partir d'un élément à résistance dynamique commandée.

2. Circuit réjecteur selon la revendication 1, caractérisé en ce que la capacité parallèle est constituée au moyen de deux diodes à capacité variable montées en série avec leurs sens de conduction opposés, dont le point commun est relié par une résistance ou par une inductance à une source de tension de commande.

3. Circuit réjecteur selon la revendication 1, caractérisé en ce que, la résistance dynamique de l'élément à résistance dynamique commandée étant commandée par le courant continu qui le traverse, une extrémité de l'élément à résistance dynamique commandée est reliée par une résistance ou par une inductance à une source de tension de commande, et son autre extrémité est reliée par une résistance ou par une inductance à une source de tension fixe.

4. Circuit réjecteur selon la revendication 3, caractérisé en ce que la capacité parallèle est constituée au moyen de deux diodes à capacité variable montées en série et avec leurs sens de conduction opposés, dont le point commun est relié par une résistance ou par une inductance à la même source de tension de commande que l'élément à résistance dynamique commandée.

5. Circuit réjecteur selon la revendication 1, caractérisé en ce que l'élément à résistance dynamique commandée est une diode dite P.I.N.

6. Circuit réjecteur selon la revendication 1, caractérisé en ce qu'une résistance fixe est connectée en parallèle avec l'élément à résistance dynamique commandée.

7. Circuit réjecteur selon la revendication 6, caractérisé en ce qu'une capacité est connectée en série avec la résistance fixe.

8. Circuit réjecteur selon la revendication 1, caractérisé en ce qu'une capacité fixe shuntée par une résistance est montée en série avec la capacité parallèle.

9. Tête de réseau d'une installation de distribution par câble, caractérisée en ce qu'elle comporte un circuit réjecteur selon l'une quelconque des revendications 1 à 8.
